# EUROPÄISCHE PATENTSCHRIFT

(11) **EP 2 531 869 B1**
(45) Veröffentlichungstag und Bekanntmachung des Hinweises auf die Patenterteilung: **19.10.2016**
(21) Anmeldenummer: 11703416.5
(22) Anmeldetag: 02.02.2011
(51) Int. Cl.: G01R 31/36, H02J 7/00

(54) **VORRICHTUNG UND VERFAHREN ZUR BESTIMMUNG EINES BEREICHS EINER BATTERIEKENNLINIE**
DEVICE AND METHOD FOR DETERMINING A RANGE OF A BATTERY CHARACTERISTIC CURVE
DISPOSITIF ET PROCÉDÉ POUR DÉTERMINER UNE ZONE D'UNE LIGNE CARACTÉRISTIQUE DE BATTERIE

(30) Priorität: 05.02.2010 DE 102010006965
(43) Veröffentlichungstag der Anmeldung: 12.12.2012
(73) Patentinhaber: Continental Automotive GmbH, 30165 Hannover (DE)
(72) Erfinder: DAISS, Armin, 93051 Regensburg (DE)
(86) Internationale Anmeldenummer: PCT/EP2011/051473
(87) Internationale Veröffentlichungsnummer: WO 2011/095513

(56) Entgegenhaltungen:
- EP-A1- 1 906 193
- US-A1- 2005 046 388
- US-B1- 6 366 054

## Beschreibung

Die Erfindung betrifft eine Vorrichtung und ein Verfahren zur Bestimmung eines Bereichs einer Batteriekennlinie.

Das Energiemanagement in Kraftfahrzeugen gewinnt zunehmend an Bedeutung. Die Ursache liegt in der zunehmenden Elektrifizierung, dass heißt einer erhöhten Anzahl von elektrischen Geräten und Verbrauchern welche mit Energie versorgt werden müssen. Diese Energie wird unter anderem von der Fahrzeugbatterie bereitgestellt. Hinzu kommt, dass die einzelnen Verbraucher verschiedene Prioritäten hinsichtlich ihrer Versorgung haben. Beispielsweise muss sichergestellt sein, dass sicherheitsrelevante Verbraucher mit Energie versorgt werden können; dazu zählen die Bremsen, die Beleuchtung und Airbags. Für eine Sicherstellung der Energieversorgung, vor allem sicherheitsrelevanter Verbraucher, ist es unter anderem erforderlich, den Zustand beziehungsweise die charakteristischen Größen der Fahrzeugbatterie kontinuierlich zu erfassen und zu überwachen. Eine wichtige Zustandsgröße der Fahrzeugbatterie ist der Ladungszustand oder auch State of Charge (SOC). Eine weitere charakteristische Größe der Fahrzeugbatterie ist die sogenannte Ruhespannung oder auch Open Circuit Voltage (OCV). Mit dieser Ruhespannung kann der Ladezustand der Fahrzeugbatterie ermittelt werden. Dazu kann eine charakteristische OCV-SOC Batteriekennlinie benutzt werden. Es hat sich herausgestellt, dass für einen großen Teil von Batterien europäischer Hersteller, wie beispielsweise Banner, Exide und JCI, eine einheitliche Kennlinie verwendet werden kann. Diese OCV-SOC Kennlinie für Batterien europäischer Hersteller ist unterschiedlich zu den Kennlinien von Batterien von Herstellern aus anderen Kontinenten, insbesondere zu Batterien von asiatischen Herstellern.

Druckschrift EP 1 906 193 A1 schlägt eine Vorrichtung zur Bestimmung wenigstens eines Bereichs einer Batteriekennlinie für eine Batterie in einem Fahrzeug vor. Die Vorrichtung umfasst dabei eine Messvorrichtung zur Messung von Batterieparametern und eine Auswerteeinheit, die Mittel zur Bestimmung des aktuellen Ladungszustands der Batterie aus den gemessenen Batterieparametern aufweist.

Es ist daher Aufgabe der vorliegenden Erfindung, eine Vorrichtung und ein Verfahren bereitzustellen, welche eine Bestimmung eines Bereichs einer OCV-SOC Kennlinie für eine größere Anzahl von Batterien als bisher bereitstellt.

Diese Aufgabe wird durch eine Vorrichtung nach Anspruch 1, ein Batterieüberwachungssystem nach Anspruch 6 und ein Verfahren nach Anspruch 7 gelöst.

In einem ersten Aspekt umfasst die Erfindung eine Vorrichtung zur Bestimmung wenigstens eines Bereichs einer, Batteriekennlinie für eine Batterie in einem Fahrzeug mit
- einer Messvorrichtung zur Messung von Batterieparametern,
- einer Auswerteeinheit umfassend
   - Mittel zur Bestimmung des aktuellen Ladungszustands der Batterie aus den gemessenen Batterieparametern,
   - Mittel zur Bestimmung eines Verschiebungswerts aus der Differenz eines gemessenen Batterieparameters und einem Standard-Wert welcher aus einer Standard-Batteriekennlinie unter Berücksichtigung des bestimmten Ladungszustands bestimmt wird,
   - Mittel zur Ermittlung wenigstens eines Bereiches einer neuen Batteriekennlinie durch Addition des Verschiebungswertes zu der Standard-Batteriekennlinie.

Zweckmäßigerweise umfasst die Messvorrichtung Mittel zu Messung von Spannung, Strom, Temperatur und Zeit. Der Strom wird beispielsweise an einem Standardwiderstand, einem sogenannten Shunt, gemessen. Die Spannung wird direkt an der Batterie, beispielsweise mit einem Widerstandsteiler gemessen. Die Temperatur kann mit einem dafür vorgesehenen Sensor oder einem temperaturabhängigen Widerstand gemessen werden. Die Zeit kann mittels eines Oszillators, welcher in der Vorrichtung angeordnet sein kann, gemessen. Dadurch können die wesentlichen Batterieparameter gemessen werden.

In einer vorteilhaften Ausgestaltung umfasst die Auswerteeinheit Mittel zur Bestimmung des Verschiebungswerts aus der Differenz der gemessenen Ruhespannung der Batterie und einer Standard- Ruhespannung, welche aus einer Standard-Batteriekennlinie bei dem bestimmten Ladungszustand ermittelt wird. Dadurch wird erreicht, dass der Bereich der Batteriekennlinie durch Verschiebung der OCV-Werte erfolgt.

In einer weiteren vorteilhaften Ausgestaltung umfasst die Auswerteeinheit Mittel zur Bestimmung des Verschiebungswerts aus der Differenz des bestimmten Ladungszustands der Batterie und einem Standard-Ladungszustand welche aus einer Standard-Batteriekennlinie bei der gleichen Ruhespannung ermittelt wird. Dadurch wird erreicht, dass der Bereich der Batteriekennlinie durch Verschiebung der SOC-Werte erfolgt.

In einer vorteilhaften Ausgestaltung ist die Vorrichtung in einen ASIC (Application Specific Integrated Circuit) integriert.

In einem zweiten Aspekt umfasst die Erfindung ein Verfahren zur Bestimmung wenigstens eines Bereichs einer Batteriekennlinie für eine Batterie in einem Fahrzeug mit folgenden Verfahrensschritten:
- Bestimmung des aktuellen Ladungszustands der Batterie aus gemessenen Batterieparametern,
- Bestimmung eines Verschiebungswerts aus der Differenz eines gemessenen Batterieparameters und einem Standard-Wert welcher aus einer Standard-Batteriekennlinie unter Berücksichtigung des bestimmten Landungszustands,
- Ermittlung wenigstens eines Bereichs einer neuen Batteriekennlinie durch Addition des Verschiebungswertes zu der Standard-Batteriekennlinie.

Ferner wird eine Batterieüberwachungsvorrichtung vorgeschlagen, umfassend
- die Vorrichtung,
- eine Batterieklemme welche mechanisch und elektrisch sowohl mit der Batterie als auch mit der Vorrichtung verbunden ist,
- einen Messwiderstand, der mechanisch und elektrisch mit der Batterieklemme und der Vorrichtung verbunden ist.

Weitere Einzelheiten und Vorteile werden in Bezugnahme auf die beigefügten Figuren erläutert.

Darin zeigen schematisch:
- Fig. 1: Vorrichtung zur Bestimmung eines Bereiches einer Batteriekennlinie;
- Fig. 2: Verfahren zur Bestimmung eines Bereiches einer Batteriekennlinie; und
- Fig. 3: Charakteristische OCV-SOC-Kennlinie.

Bei der nachfolgenden Beschreibung bezeichnen gleiche Bezugszeichen gleiche oder vergleichbare Komponenten.

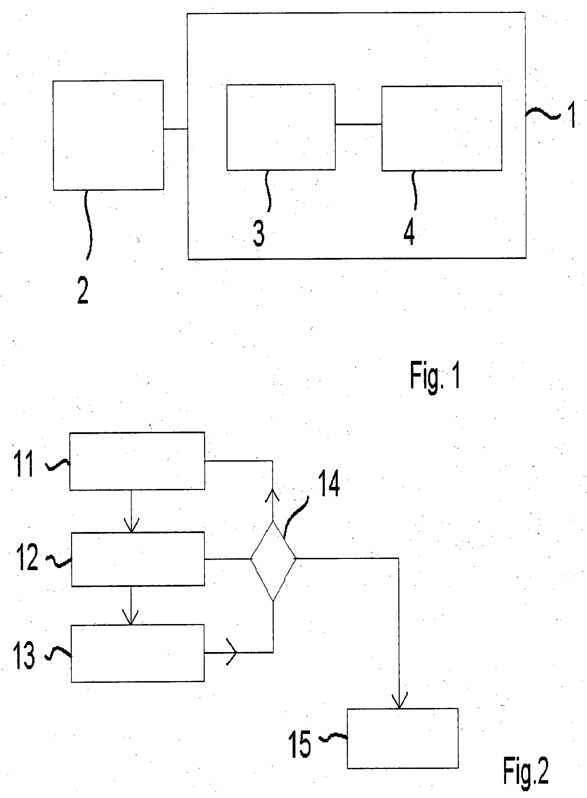

Die Figur 1 zeigt eine Batterie 2 und die Vorrichtung 1, umfassend eine Messvorrichtung 3 und eine Auswerteeinheit 4. Die Messvorrichtung 3 misst Batterieparameter wie Spannung, Strom und auch die korrespondierende Zeit dieser Messungen. Zur Bestimmung wenigstens eines Bereichs der Batteriekennlinie umfasst die Auswerteeinheit 4
- Mittel zur Bestimmung des aktuellen Ladungszustands (SOC) der Batterie (2) aus den gemessenen Batterieparametern,
- Mittel zur Bestimmung eines Verschiebungswerts (VW) aus der Differenz eines gemessenen Batterieparameters und einem Standard-Wert welcher aus einer Standard-Batteriekennlinie unter Berücksichtigung des bestimmten Ladungszustands (SOC) ermittelt wird,
- Mittel zur Ermittlung wenigstens eines Bereichs einer neuen Batteriekennlinie durch Addition des Verschiebungswertes (VW) zu der Standard-Batteriekennlinie.

Der Strom wird beispielsweise an einem Standardwiderstand, einem sogenannten Shunt, gemessen. Die Spannung wird direkt an der Batterie, beispielsweise mit einem Widerstandsteiler gemessen. Die Temperatur kann mit einem dafür vorgesehenen Sensor oder einem temperaturabhängigen Widerstand gemessen werden. Die Zeit,kann mittels eines Oszillators, welcher in der Vorrichtung angeordnet sein kann, gemessen.

Der Ladungszustand einer Batterie ist der Quotient des aktuellen Ladungszustands der Batterie 2 und des maximalen Ladungszustands der Batterie 2; dieser wird also als relativer Wert zur möglichen Gesamtladung der Batterie 2 angegeben. Die Ruhespannung der Batterie 2 wird dann gemessen, wenn in der Batterie 2 keine chemischen Reaktionen mehr stattfinden, d.h. erfahrungsgemäß nach einigen Stunden. Die Ruhespannung ist auch unter open circuit voltage (OCV) und der Ladungszustand auch unter state of charge (SOC) bekannt.

Bei Batterien 2 wird durch den Hersteller vorgegeben, wieviel Kapazität verfügbar ist. Diese Kapazitäts-Kennzahl wird in Amperestunden (Ah) angegeben. Dieser Kapazitäts-Wert entspricht direkt nach der Aufladung der Batterie durch den Hersteller einem SOC von 100 %. Bei ausgelieferten Batterien ist zwar eine zeitlich bedingte geringfügige Batteriealterung erfolgt, die aber keinen entscheidenden Einfluss auf die Gesamtkapazität und den SOC-Wert bei 100 % hat. Daher wird für die Bestimmung des SOC der ursprüngliche Kapazitätswert des Herstellers verwendet. Dieser Wert wird beim Einbau einer neuen Batterie in einem fahrzeugseitigen Speicher hinterlegt, welcher bei Bedarf durch die Vorrichtung 1 ausgelesen werden kann. Der Speicher kann auch in die Vorrichtung 1 integriert sein. Wenn die Batterie 2 eine deutliche Verringerung der ursprünglichen Kapazität aufgrund des Alterungsprozesses aufweist, sollte der aktuelle SOC-Wert in Relation zum SOC von 100 % bestimmt werden. Beispielsweise könnte die aktuelle Kapazität durch die Messung des Stromes über die Zeit bei einer vollständigen Entladung bestimmt werden.

Zur Bestimmung des aktuellen SOC-Werts wird beispielsweise, ausgehend von einer voll aufgeladenen Batterie, die Kapazitätsentnahme bestimmt. Dazu wird der abfließende Strom pro Zeiteinheit durch die Messvorrichtung 3 gemessen und in der Auswerteeinheit 4 über die Zeit integriert. Das Verhältnis des bestimmten Kapazitätswerts zu dem Kapazitätswert bei einem SOC bei 100 % entspricht dem aktuellen SOC der Batterie 2. Beispielhaft sei die Kapazität einer Autobatterie 40 Ah bei einem SOC von 100 %. Wird ein Abfluss von 10 Ah bestimmt, so ergibt sich ein SOC zu 75 %.

Zur Erkennung, ob eine Batterie gerade voll aufgeladen ist wird der zu- bzw. abfließende Strom von der Batterie analysiert. Eine volle Batterie nimmt nur noch wenig Strom auf.

Der korrespondierende OCV-Wert wird wie oben beschrieben, nach einer längeren Ruhephase der Batterie 2 durch die Mess-Vorrichtung 3 gemessen.

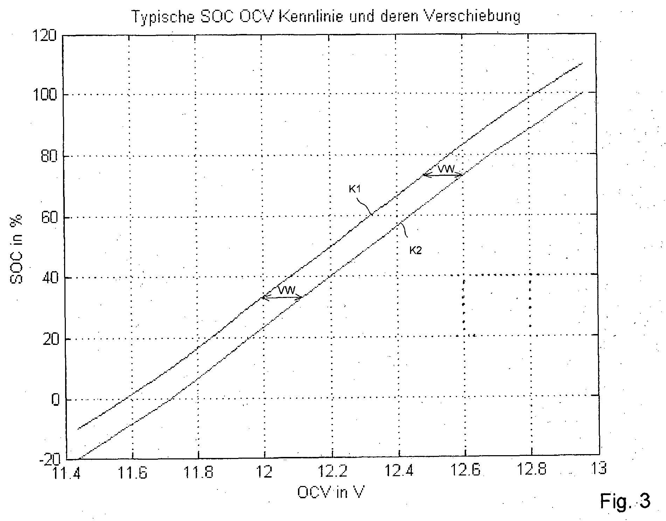

Aus der Differenz des gemessenen OCV-Werts und des OCV-Werts. einer Standard-Kennlinie bei gleichem SOC-Wert, wird ein Verschiebungswert VW in der Auswerteeinheit 4 bestimmt. Als Standard Kennlinie kann beispielsweise die Kennlinie von sogenannten nassen Batterien, d.h. Blei-Säure Batterien bei denen die Säure zwischen den Elektrolyt-Platten der Batterie frei beweglich ist, der Hersteller Banner, Exide und JCI verwendet werden, vgl. Kurve K1 in der Figur 3. Dieser Verschiebungswert VW entspricht dem Wert, um den die Kennlinie der neuen Batterie gegenüber der Standardbatterie verschoben ist. Das heißt den OCV-Werten der Standard OCV-SOC-Kennlinie wird lediglich der Verschiebungswert VW hinzuaddiert, um die OCV-SOC Kennlinie für die aktuelle Batterie 2 zu erhalten. Analog hierzu kann bei einem gleichen OCV-Wert auch die Differenz des SOC-Werts hinzuaddiert werden, um die neue Kennlinie zu erhalten. Hierbei wird angenommen, dass die OCV-SOC-Kennlinien linear sind, so dass die Kennlinie der aktuellen Batterie 2 parallel zur Standardbatterie verschoben ist. Diese Verschiebung ist auch mit dem SOC-Wert bei gleichem OCV-Wert möglich. Zu beachten ist, dass bei sehr kleinen und großen OCV-Werten der korrespondierende SOC-Wert außerhalb des Koordinatensystems liegen kann. Dem kann dadurch begegnet werden, dass die Kennlinie, ausgehend vom linearen Bereich, bis zu dem gewünschten Bereich interpoliert wird.

Es ist üblich, die Bestimmung des SOC, OCV und der Batterieparameter bei einer Temperatur von 25 °C durchzuführen. Daher wird bei allen Messungen auch die Temperatur jeweils gemessen.

Zusätzlich kann je nach Batterietyp die Steigung der Kennlinien variieren. Üblicherweise werden die Batteriekenndaten beim Einbau einer neuen Batterie von einem fahrzeugseitigen Steuergerät, beispielsweise der Motorsteuerung ausgelesen. Von der Motorsteuerung können diese Daten von der erfindunggemäßen Vorrichtung ausgelesen und verwendet werden und eine entsprechende Vergleichskennlinie und die zugehörige Steigung zugeordnet werden. Daher ist es geboten, in dem Speicher der erfindungsgemäßen Vorrichtung mehrere übliche Standard-Batteriekennlinien zu hinterlegen.

Diese Verschiebung ist auch für Kurven anwendbar, die nicht linear sind. Voraussetzung ist, dass die Kurven zueinander parallel verschoben sind.

Diese sogenannte Lernphase findet üblicherweise unmittelbar nach dem erstmaligen Start des Fahrzeugs, d.h. mit einer neuen Batterie, statt und endet nachdem der Verschiebungswert und die Kennlinie bestimmt wurden. Die Lernphase beginnt auch wenn eine neue Batterie eingebaut wurde und als solche erkannt wurde. Die Bestimmung des Verschiebungswerts wird so oft wiederholt, bis der Verschiebungswert VW nur noch eine geringe, d.h. eine vorher festgelegte, Abweichung vom vorherigen Wert aufweist.

Weiterhin ist eine Batterieüberwachungseinrichtung (nicht dargestellt) vorgesehen, umfassend eine Vorrichtung 1, eine Batterie 2, eine Batterieklemme und einen Messwiderstand. Die Batterieklemme ist mechanisch und elektrisch sowohl mit der Batterie 2 als auch mit der Vorrichtung 1 verbunden. Der Messwiderstand ist mechanisch und elektrisch mit der Batterieklemme und der Vorrichtung 1 verbunden. Mit dem Messwiderstand können Batterieparameter wie Spannung und Strom gemessen werden und von der Vorrichtung 1 zur Ermittlung wenigstens eines Bereichs einer Batteriekennlinie verwendet werden.

Figur 2 zeigt ein Verfahren zur Bestimmung eines Bereichs der Batteriekennlinie.

In einem ersten Schritt 11 wird der aktuelle SOC-Wert der Batterie 2 bestimmt. Diese Bestimmung kann durch die Messung der entnommenen Kapazität bei voll aufgeladener Batterie erfolgen. Dabei wird der gemessene Strom über die Zeit integriert. Diese Messung und Integration kann während der Fahrt oder auch direkt beim Startvorgang erfolgen.

In einem zweiten Schritt 12 wird die Ruhespannung der Batterie 2 gemessen. Dies erfolgt nach längerer Ruhephase der Batterie, so dass keine chemischen Reaktionen mehr ablaufen.

Bei der Kennlinie der Standardbatterie kann es sich um eine Kennlinie für eine Batterie eines europäischen Herstellers, s.o., handeln. Die korrespondierenden OCV- und SOC-Werte der Standardbatterie können in der Auswerteeinheit 4 oder in einem Speicher außerhalb der Auswerteeinheit 4 abgelegt sein.

In einem dritten Schritt 13 wird ein Verschiebungswert VW bestimmt, welcher die Differenz des gemessenen OCV-Werts zu einem OCV-Wert einer Standard-Kennlinie darstellt, wobei beide OCV-Werte dem gleichen SOC-Wert zugeordnet sind. Das heißt, der SOC-Wert, bei dem der OCV-Wert der vorhandenen Batterie 2 gemessen wurde wird verwendet, um aus der Standard-Kennlinie den dortigen OCV-Wert herauszulesen. Der Verschiebungswert VW kann allerdings auch aus der Differenz des bestimmten SOC-Werts und einem SOC-Wert aus einer Standard OCV-SOC-Kennlinie ermittelt werden.

In einem vierten Schritt 14 wird bestimmt wie groß der Unterschied des eben berechneten Verschiebungswerts VW zu dem vorherigen Verschiebungswert VW ist. Die Berechnung des Verschiebewert VWs wird so oft wiederholt, d.h. das Erfahren bei Schritt 11 wieder begonnen, bis der aktuelle Verschiebungswert VW nur noch eine vorher festgelegte Abweichung aufweist.

In einem fünften Schritt 15 wird der in Schritt 14 verifizierte Verschiebewert VW der OCV-SOC-Standard-Kennlinie hinzuaddiert, so dass eine charakteristische Kennlinie basierend auf der bekannten Kennlinie bestimmt wurde.

Figur 3 zeigt charakteristische Kennlinien K1 und K2 der Ruhespännung OCV zu Ladungszuständen SOC für beispielhafte Batterien 2. Die Kurve K1 ist, wie oben beschrieben, eine Standard-Kennlinie. Die Kennlinie K2 ist um einen OCV-Verschiebungswert VW von der Kennlinie K1 verschoben. Näherungsweise sind beide Kennlinien K1, K2 im SOC-Bereich von 30%-90% Geraden, deren Steigungen vergleichbar sind. Es ist daher besonders vorteilhaft, einen Verschiebungswert VW in dem SOC-Bereich von 30%-90% zu ermitteln, da hier die Kennlinien linear sind.

Die Erfindung eignet sich für die Ermittlung von Bereichen für Batteriekennlinien für Kraftfahrzeugbatterien.

## Patentansprüche

1. Vorrichtung (1) zur Bestimmung wenigstens eines Bereichs einer Batteriekennlinie für eine Batterie (2) in einem Fahrzeug, umfassend
- eine Messvorrichtung(3) zur Messung von Batterieparametern,
- eine Auswerteeinheit (4) umfassend
- Mittel zur Bestimmung des aktuellen Ladungszustands (SOC) der Batterie (2) aus den gemessenen Batterieparametern,
**dadurch gekennzeichnet, dass** die Auswerteeinheit weiter umfaßt
- Mittel zur Bestimmung eines Verschiebungswerts (VW) aus der Differenz eines gemessenen Batterieparameters und einem Standard-Wert welcher aus einer Standard-Batteriekennlinie unter Berücksichtigung des bestimmten Ladungszustands (SOC) ermittelt wird,
- Mittel zur Ermittlung wenigstens eines Bereichs einer neuen Batteriekennlinie durch Addition des Verschiebungswertes (VW) zu der Standard-Batteriekennlinie,
wobei
- die Auswerteeinheit (4) Mittel umfasst zur Bestimmung des Versc-hiebungswerts (VW) aus der Differenz der gemessenen Ruhespannung (OCV) der Batterie (2) und einer Standard- Ruhespannung (OCV-Standard), welche aus einer Standard-Batteriekennlinie bei dem bestimmten Ladungszustand (SOC) ermittelt wird.

2. Vorrichtung (1) nach Anspruch 1, **dadurch gekennzeichnet, dass** die Messvorrichtung (3) Mittel zur Messung von Spannung und Strom der Batterie (2) sowie Zeit umfasst.

3. Vorrichtung (1) nach Anspruch 1 oder 2, **dadurch gekennzeichnet, dass** die Auswertevorrichtung (4) Mittel umfasst zur Bestimmung des Verschiebungswerts (VW) aus der Differenz des bestimmten Ladungszustands (SOC) der Batterie (2) und einem Standard-Ladungszustand (SOC-Standard) welche aus einer Standard OCV-SOC-Batteriekennlinie bei der gleichen Ruhespannung (OCV) ermittelt wird.

4. Vorrichtung (1) nach einem der vorherigen Ansprüche, welche in einen ASIC integriert ist.

5. Batterieüberwachungsvorrichtung, umfassend
- eine Vorrichtung (1) nach einem der vorherigen Ansprüche,
- eine Batterieklemme welche mechanisch und elektrisch sowohl mit der Batterie (2) als auch mit der Vorrichtung (1) verbunden ist,
- einen Messwiderstand, der mechanisch und elektrisch mit der Batterieklemme und der Vorrichtung (1) verbunden ist.

6. Verfahren zur Bestimmung wenigstens eines Bereichs einer Batteriekennlinie für eine Batterie (2) in einem Fahrzeug mit folgenden Verfahrensschritten:
- Bestimmung des aktuellen Ladungszustands (SOC) der Batterie (2) aus gemessenen Batterieparametern,
- Bestimmung eines Verschiebungswerts (VW) aus der Differenz eines gemessenen Batterieparameters und einem Standard-Wert welcher aus einer Standard-Batteriekennlinie unter Berücksichtigung des bestimmten Landungszustands (SOC) bestimmt wird,
- Ermittlung wenigstens eines Bereichs einer neuen Batteriekennlinie durch Addition des Verschiebungswertes (VW) zu der Standard-Batteriekennlinie.

7. Verfahren nach Anspruch 6, wobei die Bestimmung des Verschiebungswerts (VW) aus der Differenz der gemessenen Ruhespannung (OCV) der Batterie (2) und einer Standard- Ruhespannung (OCV-Standard) erfolgt, welche aus einer Standard-Batteriekennlinie bei dem bestimmten Ladungszustand (SOC) ermittelt wird.

8. Verfahren nach Anspruch 6, wobei die Bestimmung des Verschiebungswerts (VW) aus der Differenz des bestimmten Ladungszustands (SOC) der Batterie (2) und einem Standard-Ladungszustand (SOC-Standard) erfolgt, welche aus einer Standard-Batteriekennlinie bei der gleichen Ruhespannung (OCV) ermittelt wird

9. Verfahren nach einem der Ansprüche 6 bis 8, wobei der aktuelle Ladungszustand (SOC) der Batterie (2) durch das Verhältnis der abgeflossenen Kapazität zur maximalen Kapazität der Batterie (2) bestimmt wird.

10. Verfahren nach einem der Ansprüche 6 bis 9, wobei die abgeflossene Kapazität der Batterie (2) durch die Integration des gemessenen Stromes der Batterie (2) über die Zeit bestimmt wird.

11. Verfahren nach einem der Ansprüche 6 bis 10, wobei der abfließende Strom der Batterie (2) während des Startvorganges des Fahrzeugs gemessen wird.

12. Verfahren nach einem der Ansprüche 6 bis 11, wobei die Batteriekennlinie im Bereich 30%-90% des SOC-Bereichs ermittelt wird.

## Claims

1. Device (1) for determining at least one portion of a battery characteristic curve for a battery (2) in a vehicle, comprising
- a measuring device (3) for measuring battery parameters,
- an evaluation unit (4) comprising
- means for determining the current state of charge (SOC) of the battery (2) from the measured battery parameters,
**characterized in that** the evaluation unit further comprises
- means for determining a shift value (VW) from the difference between a measured battery parameter and a standard value which is obtained from a standard battery characteristic curve taking into account the determined state of charge (SOC),
- means for obtaining at least one portion of a new battery characteristic curve by adding the shift value (VW) to the standard battery characteristic curve, wherein
- the evaluation unit (4) comprises means for determining the shift value (VW) from the difference between the measured open circuit voltage (OCV) of the battery (2) and a standard open circuit voltage (OCV standard), which difference is obtained from a standard battery characteristic curve with the determined state of charge (SOC).

2. Device (1) according to Claim 1, **characterized in that** the measuring device (3) comprises means for measuring the voltage and current of the battery (2) as well as time.

3. Device (1) according to Claim 1 or 2, **characterized in that** the evaluation device (4) comprises means for determining the shift value (VW) from the difference between the determined state of charge (SOC) of the battery (2) and a standard state of charge (SOC standard), which difference is obtained from a standard OCV/SOC battery characteristic curve with the same open circuit voltage (OCV).

4. Device (1) according to one of the preceding claims, which device (1) is integrated into an ASIC.

5. Battery monitoring device, comprising
- a device (1) according to one of the preceding claims,
- a battery terminal which is connected mechanically and electrically both to the battery (2) and to Device (1),
- a measuring resistor which is mechanically and electrically connected to the battery terminal and to Device (1).

6. Method for determining at least one portion of a battery characteristic curve of a battery (2) in a vehicle, having the following method steps:
- the current state of charge (SOC) of the battery (2) is determined from measured battery parameters,
- a shift value (VW) is determined from the difference between a measured battery parameter and a standard value which is determined from a standard battery characteristic curve taking into account the determined state of charge (SOC), and
- at least one portion of a new battery characteristic curve is obtained by adding the shift value (VW) to the standard battery characteristic curve.

7. Method according to Claim 6, wherein the shift value (VW) is determined from the difference between the measured open circuit voltage (OCV) of the battery (2) and a standard open circuit voltage (OCV standard), which difference is obtained from a standard battery characteristic curve with the determined state of charge (SOC).

8. Method according to Claim 6, wherein the shift value (VW) is determined from the difference between the determined state of charge (SOC) of the battery (2) and a standard state of charge (SOC standard), which difference is obtained from a standard battery characteristic curve with the same open circuit voltage (OCV).

9. Method according to one of Claims 6 to 8, wherein the current state of charge (SOC) of the battery (2) is determined by the ratio of the discharged capacity to the maximum capacity of the battery (2).

10. Method according to one of Claims 6 to 9, wherein the discharged capacity of the battery (2) is determined by integrating the measured current of the battery (2) over time.

11. Method according to one of Claims 6 to 10, wherein the discharging current of the battery (2) is measured during the starting process of the vehicle.

12. Method according to one of Claims 6 to 11, wherein the battery characteristic curve is obtained in the range of 30% to 90% of the SOC portion.

## Revendications

1. Dispositif (1) destiné à déterminer au moins une région d'une courbe caractéristique de batterie pour une batterie (2) dans un véhicule, comprenant
- un dispositif de mesure (3) destiné à mesurer des paramètres de batterie,
- une unité d'analyse (4) comprenant
- des moyens destinés à déterminer l'état de charge (SOC) actuel de la batterie (2) à partir des paramètres de batterie mesurés,
**caractérisé en ce que** l'unité d'analyse comprend en outre
- des moyens destinés à déterminer une valeur de décalage (VW) à partir de la différence entre un paramètre de batterie mesuré et une valeur standard qui est déterminée à partir d'une courbe caractéristique de batterie standard en tenant compte de l'état de charge (SOC) déterminé,
- des moyens destinés à déterminer au moins une région d'une nouvelle courbe caractéristique de batterie par addition de la valeur de décalage (VW) à la courbe caractéristique de batterie standard,
dans lequel
- l'unité d'analyse (4) comprend des moyens destinés à déterminer la valeur de décalage (VW) à partir de la différence entre la tension de repos mesurée (OCV) de la batterie (2) et une tension de repos standard (OCV-Standard) qui est déterminée à partir de la courbe caractéristique de batterie standard pour l'état de charge (SOC) déterminé.

2. Dispositif (1) selon la revendication 1, **caractérisé en ce que** le dispositif de mesure (3) comprend des moyens destinés à mesurer la tension et le courant de la batterie (2) ainsi que le temps.

3. Dispositif (1) selon la revendication 1 ou 2, **caractérisé en ce que** le dispositif d'analyse (4) comprend des moyens destinés à déterminer la valeur de décalage (VW) à partir de la différence entre l'état de charge (SOC) déterminé de la batterie (2) et un état de charge standard (SOC-Standard) qui est déterminé à partir d'une courbe caractéristique de batterie OCV-SOC Standard pour la même tension de repos (OCV).

4. Dispositif (1) selon l'une quelconque des revendications précédentes, qui est intégré à un circuit ASIC.

5. Dispositif de surveillance de batterie, comprenant :
- un dispositif (1) selon l'une quelconque des revendications précédentes,
- une borne de batterie qui est reliée mécaniquement et électriquement à la batterie (2) ainsi qu'au dispositif (1),
- une résistance de mesure qui est reliée mécaniquement et électriquement à la borne de batterie et au dispositif (1).

6. Procédé de détermination d'au moins une région d'une courbe caractéristique pour une batterie (2) dans un véhicule, comportant les étapes consistant à :
- déterminer l'état de charge (SOC) actuel de la batterie (2) à partir de paramètres de batterie mesurés,
- déterminer une valeur de décalage (VW) à partir de la différence entre un paramètre de batterie mesuré et une valeur standard qui est déterminée à partir d'une courbe caractéristique de batterie standard en tenant compte de l'état de charge (SOC) déterminé,
- déterminer au moins une région d'une nouvelle courbe caractéristique de batterie par addition de la valeur de décalage (VW) à la courbe caractéristique de batterie standard.

7. Procédé selon la revendication 6, dans lequel la détermination de la valeur de décalage (VW) est effectuée à partir de la différence entre la tension de repos mesurée (OCV) de la batterie (2) et une tension de repos standard (OCV-Standard) qui est déterminée à partir d'une courbe caractéristique de batterie standard pour l'état de charge (SOC) déterminé.

8. Procédé selon la revendication 6, dans lequel la détermination de la valeur de décalage (VW) est effectuée à partir de la différence entre l'état de charge (SOC) déterminé de la batterie (2) et un état de charge standard (SOC-Standard) qui est déterminé à partir d'une courbe caractéristique de batterie standard pour la même tension de repos (OCV).

9. Procédé selon l'une quelconque des revendications 6 à 8, dans lequel l'état de charge (SOC) actuel de la batterie (2) est déterminé par le rapport de la capacité prélevée à la capacité maximale de la batterie (2).

10. Procédé selon l'une quelconque des revendications 6 à 9, dans lequel la capacité prélevée de la batterie (2) est déterminée par intégration du courant mesuré de la batterie (2) au cours du temps.

11. Procédé selon l'une quelconque des revendications 6 à 10, dans lequel le courant prélevé de la batterie (2) est mesuré pendant le processus de démarrage du véhicule.

12. Procédé selon l'une quelconque des revendications 6 à 11, dans lequel la courbe caractéristique de batterie est déterminée dans la région de 30 % à 90 % de la région SOC.
